# EUROPÄISCHE PATENTSCHRIFT

(11) **EP 0 498 004 B1**
(45) Veröffentlichungstag und Bekanntmachung des Hinweises auf die Patenterteilung: **19.06.1996**
(21) Anmeldenummer: 91101538.6
(22) Anmeldetag: 05.02.1991
(51) Int. Cl.: H03D 1/18, H04L 27/06, H03K 17/66, H03K 4/94

(54) **Integrierbare Demodulatorschaltung**
Integratable demodulator circuit
Circuit démodulateur intégrable

(43) Veröffentlichungstag der Anmeldung: 12.08.1992
(73) Patentinhaber: SIEMENS AKTIENGESELLSCHAFT, D-80333 München (DE)
(72) Erfinder: Bichler, Helmut, W-8032 Gräfelfing (DE)

(56) Entgegenhaltungen:
- FR-A- 2 270 716
- FR-A- 2 404 335
- US-A- 4 339 669

## Beschreibung

Die Erfindung betrifft eine integrierbare Demodulatorschaltung.

Bei der Demodulation von modulierten digitalen Signalen wird z.B. ein amplitudenmoduliertes Übertragungssignal von einer Detektorschaltung erkannt und nachfolgend durch einen Demodulator demoduliert. Die Amplitudenmodulation des zu sendenden Signales erfolgt dabei folgendermaßen: Soll eine digitale Null übertragen werden, so wird kein Signal gesendet, soll dagegen eine digitale Eins übertragen werden, so wird ein sinusförmiges Signal mit definierter Amplitude und Frequenz übertragen. Der Empfänger wertet diese Signale aus, in dem über eine Verstärker- und Detektorstufe das gesendete Signal erkannt wird. Dabei gibt der Detektor bei Erkennen des sinusförmigen Signales für jede positive bzw. negative Halbwelle ein impulsförmiges Signal aus. Dieses impulsförmige Signal muß nun durch eine entsprechende Demodulatorstufe demoduliert werden.

Eine Schaltanordnung zur Demodulation solcher Signale ist z.B. aus FR-A-2 404 335 bekannt.

Aufgabe der Erfindung ist es, eine möglichst einfache Demodulatorschaltung anzugeben.

Diese Aufgabe wird durch die kennzeichnenden Merkmale des Patentanspruches 1 gelöst.

Ausgestaltungen und Weiterbildungen des Erfindungsgedankens sind in Unteransprüchen gekennzeichnet.

Vorteil der Erfindung ist es, daß der gesamte Demodulator voll integrierbar ist.

Ein weiterer Vorteil der Erfindung ist, daß durch geeignete Wahl der Bauelemente und Auslegung der Schaltung der gezeigte Demodulator temperaturkompensiert ist.

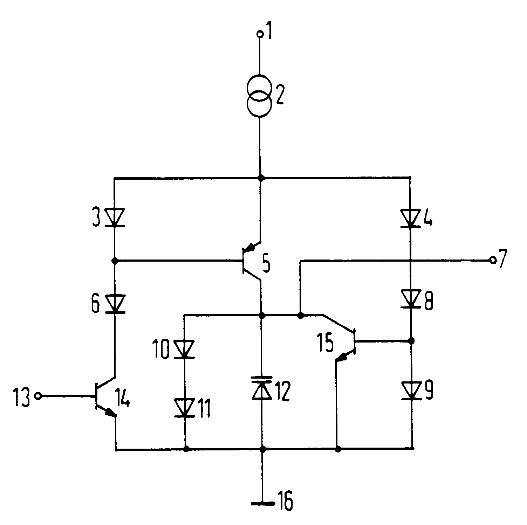

Die Erfindung wird nachfolgend anhand des in der einzigen Figur der Zeichnung dargestellten Ausführungsbeispiels näher erläutert.

Das Ausführungsbeispiel gemäß der Zeichnung umfaßt eine Eingangsklemme 1, an der die Betriebsspannung angelegt wird. Diese Eingangsklemme ist über eine Stromquelle 2 mit dem Emitter eines ersten Transistors 5 verbunden. Der Kollektor des ersten Transistors 5 ist mit dem Kollektor eines zweiten Transistors 15 sowie mit der Ausgangsklemme 7 verschaltet. Weiterhin ist die Verbindung der beiden Kollektoren mit dem ersten Anschluß einer Kapazität 12 verschaltet. Der zweite Anschluß der Kapazität ist mit dem Bezugspotential, welches im vorliegenden Beispiel Masse 16 ist, verbunden. Ebenso ist der Emitter des zweiten Transistors 15 mit Masse verbunden. Ein dritter Transistor 14 ist vorgesehen, dessen Basis mit der Eingangsklemme 13 verschaltet ist. An dieser Eingangsklemme 13 kann z.B. das Ausgangssignal einer Detektorstufe anliegen. Ebenso wie beim zweiten Transistor 15 ist der Emitter des dritten Transistors 14 mit Masse 16 verbunden. Eine Reihenschaltung aus zwei Dioden ist vorgesehen, wobei die Anode der ersten Diode 3 mit der Stromquelle 2 und die Kathode der zweiten Diode 6 mit dem Kollektor des dritten Transistors 14 verbunden ist. Weiterhin weist die Reihenschaltung der beiden Dioden 3, 6 einen Verbindungspunkt auf, der mit der Basis des ersten Transistors 5 verschaltet ist. Außerdem ist die Stromquelle über eine weitere Reihenschaltung aus drei Dioden 4, 8, 9 mit Masse verbunden. Die Kathode der dritten Diode 4 ist dabei mit dem Emitter des ersten Transistors 5 und die Kathode der fünften Diode 9 mit Masse verbunden. Zwischen der Kathode der vierten Diode 8 und der Anode der fünften Diode 9 ist ein Verbindungspunkt vorgesehen, der mit der Basis des zweiten Transistors 15 verbunden ist. Schließlich ist der erste Anschluß der Kapazität 12 über eine weitere Reihenschaltung aus zwei Dioden 10, 11 mit Masse verbunden. Die Anode der sechsten Diode 10 ist dabei mit dem ersten Anschluß der Kapazität und die Katode der siebten Diode 11 mit Masse verschaltet.

Die Funktionsweise des Demodulators beruht darauf, daß bei Anliegen eines positiven Impulses die Kapazität 12 über den ersten Transistor aufgeladen wird. Wird kein Signal an der Eingangsklemme 13 an, so wird die Kapazität über den zweiten Transistor 15 entladen.

Der Entladestrom ist dabei vorzugsweise geringer als der Ladestrom. Dadurch wird der Kondensator schneller aufgeladen als entladen. Dies ist vorteilhaft, da beim Detektieren eines sinusförmigen Signales an der Eingangsklemme 13 kein stetiges positives Signal anliegt, sondern eine Impulsfolge mit einem großen Tastverhältnis, d.h. während dem Detektieren einer sinusförmigen Schwingung liegt an der Eingangsklemme 13 vorwiegend ein "High"-Pegel an.

Das Umschalten der beiden Transistoren 5 und 15 erfolgt über die Schwellen der Dioden 3, 6; 4, 8, 9. Liegt an der Eingangsklemme 13 ein "High"-Pegel an, so schaltet der dritte Transistor 14 die Katode der zweiten Diode 6 auf Masse 16 und damit wird der Strom der Stromquelle 2 zum einen über die Dioden 3, 6 geleitet wodurch der erste Transistor 5 leitend geschaltet wird. Der zweite Teilstrom fließt dazu auch über den ersten Transistor 5 und lädt die Kapazität 12 auf. Bei Ausbleiben eines Signales an der Eingangsklemme 13 wird die Reihenschaltung der Dioden 3, 6 durch den dritten Transistor 14 hochohmig geschaltet. Dadurch kann kein Strom durch die beiden Dioden 3, 6 fließen, so daß der Transistor 5 sperrt. Der von der Stromquelle 2 eingeprägte Strom fließt nun durch die Reihenschaltung der drei Dioden 4, 8 und 9. Dadurch wird der zweite Transistor 15 leitend geschaltet und entlädt über seine Laststrecke die Kapazität 12. Die beiden Dioden 10, 11 dienen zur Begrenzung der Spannung an der Kapazität 12.

Die beiden Reihenschaltungen der Dioden 3, 6; 4, 8, 9 können auch jeweils um mehrere Dioden erweitert werden. Wesentlich ist, daß die Reihenschaltung der Dioden 3, 6 zur Ansteuerung des ersten Transistors 5 wenigstens eine Diode weniger enthält als die Reihenschaltung der Dioden 4, 8, 9 zur Ansteuerung des zweiten Transistors 15.

Zur Spannungsbegrenzung an der Kapazität können eine oder mehrere in Reihe geschaltete Dioden 10, 11 verwendet werden. Diese Dioden können evtl. auch ganz entfallen.

In Ausgestaltung der Erfindung ist die Kapazität 12 als mitintegrierbare Kapazitätsdiode vorgesehen, die sich vorteilhafterweise aufgrund dessen, daß die Kapazität auf Bezugspotential der Masse 16 geführt ist, leicht realisieren läßt und in dem übrigen Schaltkreis auftretende parasitäre Kapazitäten einen sehr geringen Einfluß auf diese Kapazität haben. Dadurch wird außerdem kein externer Kondensator und damit keine zusätzlichen Anschlüsse bei der integrierten Schaltung benötigt.

Außerdem sei bemerkt, daß auch weitere Ausführungsformen des Demodulators möglich sind, wie es gewährleistet, daß bei Anliegen eines positiven Signals an der Eingangsklemme 13 der erste Transistor 5 und bei Ausbleiben eines Signales an der Eingangsklemme 13 der zweite Transistor 15 leitend geschaltet wird.

Abschließend sei bemerkt, daß neben einer Realisierung in Bipolartechnik auch eine Realisierung in MOS-Technik möglich ist.

## Patentansprüche

1. Integrierbare Demodulatorschaltung gekennzeichnet durch eine Eingangsklemme (13) und eine Ausgangsklemme (7), eine Stromquelle (2), eine Kapazität (12), deren erster Anschluß mit einem Bezugspotential (16) verbunden ist, einen ersten Transistor (5), über dessen Laststrecke der zweite Anschluß der Kapazität (12) mit der Stromquelle (2) verbunden ist, wobei der zweite Anschluß der Kapazität (12) mit der Ausgangsklemme (7) verbunden ist, einen zweiten Transistor (15), dessen Laststrecke mit den Anschlüssen der Kapazität (12) verbunden ist, Mitteln, die bei Anliegen eines Eingangssignales an der Eingangsklemme (13) den ersten Transistor (5) leitend und den zweiten Transistor (15) sperrend schalten und bei Ausbleiben eines Eingangssignals an der Eingangsklemme (13) den ersten Transistor (5) sperrend und den zweiten Transistor (15) leitend schalten.

2. Integrierbare Demodulatorschaltung nach Anspruch 1,
**dadurch gekennzeichnet,**
daß eine erste Reihenschaltung aus mindestens zwei Dioden (3, 6) vorgesehen ist, daß die Dioden in Stromflußrichtung geschaltet sind und die erste Reihenschaltung einerseits mit der Stromquelle (2) und andererseits über die Laststrecke eines dritten Transistors (14) mit dem Bezugspotential (16) verbunden ist, die Basis des dritten Transistors (14) mit der Eingangsklemme (13) verbunden ist, die Reihenschaltung der Dioden (3, 6) einen Verbindungspunkt aufweist, der mit der Basis des ersten Transistors (5) verbunden ist, das mindestens eine gegenüber der ersten Reihenschaltung der Dioden (3, 6) mehr Dioden (4, 8, 9) aufweisende zweite Reihenschaltung vorgesehen ist, die in Stromflußrichtung zwischen der Stromquelle (2) und Bezugspotential (16) geschaltet ist, wobei die zweite Reihenschaltung der mit dem Bezugspotential (16) verbundenen Diode (9) und der vorgeschalteten Diode (8) einen Verbindungspunkt aufweist, der mit der Basis des zweiten Transistors verbunden ist.

3. Integrierbare Demodulatorschaltung nach einem der vorhergehenden Ansprüche,
**dadurch gekennzeichnet,**
daß eine Diode (10; 11) vorgesehen ist, deren Kathode mit Bezugspotential (16) und deren Anode mit dem zweiten Anschluß der Kapazität (12) verbunden ist.

4. Integrierbare Demodulatorschaltung nach Anspruch 3,
**dadurch gekennzeichnet,**
daß mehrere Dioden (10; 11) zwischen zweitem Anschluß der Kapazität (12) und Bezugspotential (16) geschaltet sind.

5. Integrierbare Demodulatorschaltung nach einem der vorhergehenden Ansprüche,
**dadurch gekennzeichnet,**
daß als Kapazität (12) eine Kapazitätsdiode vorgesehen ist.

## Claims

1. Integrable demodulator circuit, characterized by an input terminal (13) and an output terminal (7), a current source (2), a capacitor (12), the first connection of which is connected to a reference potential (16), a first transistor (5), via the load path of which the second connection of the capacitor (12) is connected to the current source (2), the second connection of the capacitor (12) being connected to the output terminal (7), a second transistor (15), the load path of which is connected to the connections of the capacitor (12), means which switch the first transistor (5) on and the second transistor (15) off given the presence of an input signal at the input terminal (13), and switch the first transistor (5) off and the second transistor (15) on in the absence of an input signal at the input terminal (13).

2. Integrable demodulator circuit according to Claim 1, characterized in that a first series circuit formed by at least two diodes (3, 6) is provided, in that the diodes are connected in the direction of current flow and the first series circuit is connected, on the one hand, to the current source (2) and, on the other hand, via the load path of a third transistor (14) to the reference potential (16), the base of the third transistor (14) is connected to the input terminal (13), the series circuit formed by the diodes (3, 6) has a junction point which is connected to the base of the first transistor (5), and in that at least a second series circuit is provided which has more diodes (4, 8, 9) than the first series circuit formed by the diodes (3, 6) and is connected in the direction of current flow between the current source (2) and the reference potential (16), the second series circuit formed by the diode (9) connected to the reference potential (16) and the upstream diode (8) having a junction point which is connected to the base of the second transistor.

3. Integrable demodulator circuit according to one of the preceding claims, characterized in that a diode (10; 11) is provided, the cathode of which is connected to the reference potential (16) and the anode of which is connected to the second connection of the capacitor (12).

4. Integrable demodulator circuit according to Claim 3, characterized in that a plurality of diodes (10; 11) are connected between the second connection of the capacitor (12) and the reference potential (16).

5. Integrable demodulator circuit according to one of the preceding claims, characterized in that a variable capacitance diode is provided as the capacitor (12).

## Revendications

1. Circuit démodulateur intégrable, caractérisé par une borne d'entrée (13) et une borne de sortie (7), une source de courant (2), une capacité (12), dont la première borne est reliée à un potentiel de référence (16), un premier transistor (5), par l'intermédiaire de la section de charge duquel la seconde borne de la capacité (12) est reliée à la source de courant (2), la seconde borne de la capacité (12) étant reliée à la borne de sortie (7), un second transistor (15), dont la section de charge est reliée aux bornes de la capacité (12), des moyens qui, lors de l'application d'un signal d'entrée à la borne d'entrée (13), placent le premier transistor (5) à l'état conducteur et le second transistor (15) à l'état bloqué et qui, en l'absence d'un signal d'entrée appliqué à la borne d'entrée (13), placent le premier transistor (5) à l'état bloqué et le second transistor (15) à l'état conducteur.

2. Circuit démodulateur intégrable suivant la revendication 1, caractérisé par le fait qu'il est prévu un premier circuit série formé d'au moins deux diodes (3,6), les diodes sont branchées dans le sens passant, le premier circuit série est relié d'une part à la source de courant (2) et d'autre part par l'intermédiaire de la section de charge d'un troisième transistor (14), au potentiel de référence (16), la base du troisième transistor (14) est reliée à la borne d'entrée (13), le circuit série des diodes (3,6) a un point de liaison, qui est relié à la base du premier transistor (5), il est prévu au moins un second circuit série, qui comporte par rapport au premier circuit série formé des diodes (3,6), un plus grand nombre de diodes (4,8,9) et qui est branché dans le sens passant entre la source de courant (2) et le potentiel de référence (16), le second circuit série formé par la diode (9), qui est reliée au potentiel de référence (16), et par la diode (8) branchée en amont ayant un point de liaison, qui est relié à la base du second transistor.

3. Circuit démodulateur intégrable suivant l'une des revendications précédentes, caractérisé par le fait qu'il est prévu une diode (10;11), dont la cathode est reliée au potentiel de référence (16) et dont l'anode est reliée à la seconde borne de la capacité (12).

4. Circuit démodulateur intégrable suivant la revendication 3, caractérisé par le fait que plusieurs diodes (10;11) sont branchées entre la seconde borne de la capacité (12) et le potentiel de référence (16).

5. Circuit démodulateur intégrable suivant l'une des revendications précédentes, caractérisé par le fait qu'une diode capacitive est prévue en tant que capacité (12).
